Europäisches Patentamt

European Patent Office

Office européen des brevets

(11) Publication number: **0 187 475 B1**

# EUROPEAN PATENT SPECIFICATION

(45) Date of publication of patent specification: 27.02.91  (51) Int. Cl.⁵: **H01L 21/90, H01L 27/10**

(21) Application number: **85308845.8**

(22) Date of filing: **04.12.85**

(54) Method of manufacturing semiconductor devices having an oxygen-containing polycristalline silicon layer.

(30) Priority: **04.12.84 JP 256274/84**

(43) Date of publication of application:
**16.07.86 Bulletin 86/29**

(45) Publication of the grant of the patent:
**27.02.91 Bulletin 91/09**

(84) Designated Contracting States:
**DE FR GB IT NL**

(56) References cited:
**US-A- 4 001 762**
**US-A- 4 406 051**

**EXTENDED ABSTRACTS, no. 79/1, May 1979, pages 447-449; H. YAMOTO et al.: "New Technology by Use of the Doped Sipos Films"**

(73) Proprietor: **SONY CORPORATION**
**7-35 Kitashinagawa 6-Chome Shinagawa-ku Tokyo 141(JP)**

(72) Inventor: **Yamoto, Hisayoshi c/o Patents Division**
**Sony Corporation 6-7-35 Kitashinagawa Shinagawa-ku Tokyo 141(JP)**
Inventor: **Suzuki, Hideo c/o Patents Division**
**Sony Corporation 6-7-35 Kitashinagawa Shinagawa-ku Tokyo 141(JP)**

(74) Representative: **Thomas, Christopher Hugo et al**
**D Young & Co 10 Staple Inn**
**London WC1V 7RD(GB)**

**Description**

This invention relates to methods of manufacturing semiconductor devices having an oxygen-containing polycrystalline silicon layer.

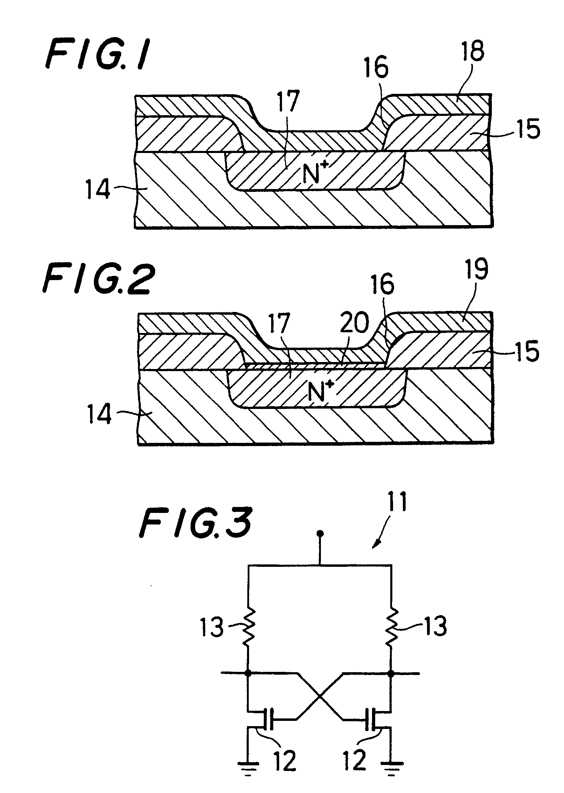

Figure 3 of the accompanying drawings shows a circuit diagram of a resistor load-type static random access memory (SRAM) in the form of a semiconductor device having a semiconductor substrate with a resistor electrically connected to the substrate, and including field effect transistors (FETs) 12 and resistors 13.

Figure 1 of the accompanying drawings shows a sectional view of a first previously-proposed example of the SRAM 11. In this example, an $SiO_2$ layer 15 is formed on an Si substrate 14. A diffusion region 17 is formed in the substrate 14 by diffusion through an opening 16 formed in the $SiO_2$ layer 15. The diffusion region 17 acts as the drain for the FET 12. A polycrystalline Si layer 18 is formed to cover the diffusion region 17 and the $SiO_2$ layer 15. The polycrystalline Si layer 18 acts as the resistor 13.

The stand-by current of the SRAM 11 is determined by the resistance of the resistor 13. In the above example, the polycrystalline Si layer 18 serving as the resistor 13 has a relatively low resistivity of $5 \times 10^5$ ohm.cm. Therefore, the stand-by current of the SRAM 11 is relatively high, and power consumption is high. These problems become particularly noticeable when a number of SRAMs 11 are integrated.

Figure 2 of the accompanying drawings shows a second previously-proposed example of the SRAM 11, forming an improvement over the first example. The SRAM 11 of this example is substantially the same as that of the first example except that a polycrystalline Si layer 19 containing oxygen is used in place of the pure polycrystalline Si layer 18.

As disclosed in issued Japanese Patent No. 55/13426, polycrystalline Si containing oxygen has a very high resistivity: about $2 \times 10^6$ ohm.cm at an oxygen content of 2%, and about $10^{10}$ ohm.cm at an oxygen content of 20%. A semiconductor device having a layer of polycrystalline Si containing oxygen formed on a semiconductor substrate is also described in issued Japanese Patent No. 53/2552.

The polycrystalline Si layer 19 containing oxygen is formed by a low-pressure chemical vapour deposition (CVD) method using, for example, $SiH_4$ (flow rate: 50 cc/min), $N_2O$ (flow rate: 2 cc/min), and $N_2$ or He as needed. In this case, in order to stabilize the $N_2O$ flow rate, only $N_2O$ is supplied for 1 to 2 minutes before the $SiH_4$ is supplied. Therefore, the Si surface of the substrate 14 is oxidized, and a thin $SiO_2$ layer 20 is formed between the diffusion region 17 and the polycrystalline Si layer 19 containing oxygen.

When P or As is doped in a connecting portion between the diffusion region 17 and the polycrystalline Si layer 19 in order to reduce the connection resistance of this connecting portion, the $SiO_2$ layer 20 becomes PSG or AsSG. Even if annealing is performed after the polycrystalline Si layer 19 has been formed, the $SiO_2$ layer 20 remains unchanged. Therefore, it is very difficult ohmically to connect the diffusion region 17 and the polycrystalline Si layer 19.

As can thus be seen, it is difficult to obtain a sufficiently high resistance with the pure polycrystalline Si layer 18, while it is also difficult ohmically to connect the polycrystalline Si layer 19 containing oxygen to the diffusion region 17.

US patent specifications US-A-4 001 762 and US-A-4 406 051 disclose further examples of semiconductor devices in which resistive elements formed of polycrystalline silicon containing oxygen are provided.

According to the present invention there is provided a method of manufacturing a semiconductor device, comprising the steps of:

forming a first polycrystalline silicon layer over at least an impurity diffusion region formed in a semiconductor substrate; and

forming a second polycrystalline silicon layer, containing oxygen, on said first polycrystalline silicon layer;

characterised in that:

said second polycrystalline silicon layer contains 2 to 10 atomic % of oxygen; and

said semiconductor substrate on which said first and second polycrystalline silicon layers are formed is annealed in a nitrogen atmosphere at 900 to 1000°C for 20 to 60 minutes.

In methods embodying the present invention, an oxide formed between the first and second polycrystalline silicon layers upon formation of the second polycrystalline silicon layer containing oxygen is dispersed over the first and second polycrystalline silicon layers, thereby ohmically connecting the electrically connecting portion of the semiconductor substrate and the second polycrystalline silicon layer. In addition, a high resistance can be obtained in the second polycrystalline silicon layer.

The invention will now be described by way of example with reference to the accompanying drawings, throughout which like parts are referred to by like references, and in which:

Figures 1 and 2 are sectional views of respective previously-proposed examples of SRAMs;

Figure 3 is a circuit diagram showing an SRAM to which the present invention can be applied;

Figure 4 is a sectional view showing steps in a first method embodying the present invention; and

Figure 5 is a sectional view showing a step in a second method embodying the present invention and corresponding to the step shown in Figure 4E.

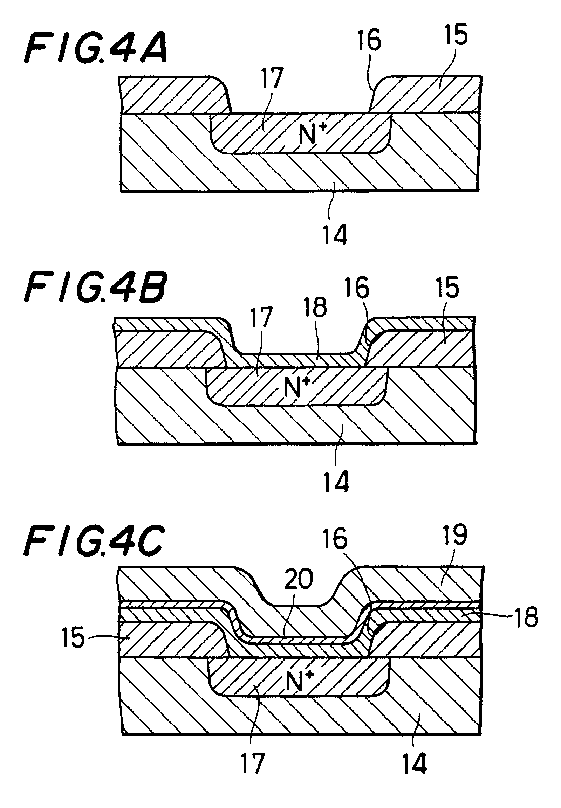

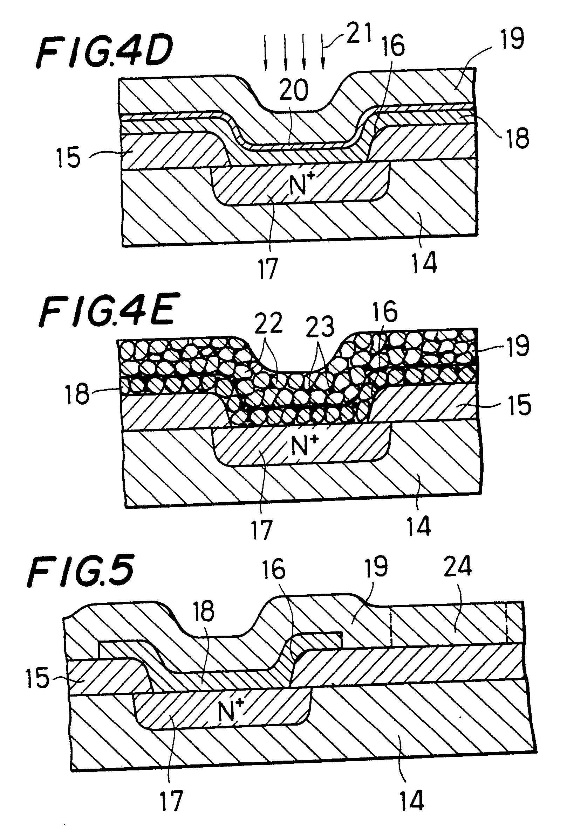

In the first method embodying the invention, as shown in Figure 4A, an $SiO_2$ layer 15 is formed on an Si substrate 14. A diffusion region 17 is formed in the substrate 14 by diffusion through an opening 16 formed in the $SiO_2$ layer 15.

Subsequently, as shown in Figure 4B, a polycrystalline Si layer 18 having a thickness of 5 to 20 nm is formed by a low-pressure CVD method on the diffusion region 17 and the $SiO_2$ layer 15. Since a gas containing oxygen is not used in this step, an $SiO_2$ layer is not formed between the diffusion region 17 and the polycrystalline Si layer 18.

As shown in Figure 4C, a polycrystalline Si layer 19 containing 2 to 10 atomic % of oxygen and having a thickness of 150 to 400 nm is then formed by a low-pressure CVD method on the polycrystalline Si layer 18. In this process, as in the case of the example of Figure 2, the polycrystalline Si layer 18 is oxidized, and an $SiO_2$ layer 20 having a thickness of about 1 to 3 nm is formed between the first and second Si layers 18 and 19.

As shown in Figure 4D, in order to reduce the connecting resistance between the diffusion region 17 and the polycrystalline Si layer 18, P or As ions 21 are ion-implanted in the connecting portion at a dose of $1 \times 10^{16} cm^{-2}$ and an acceleration energy of 70 keV.

The Si substrate 14 on which the polycrystalline Si layers 18 and 19 are formed is annealed in an $N_2$ atmosphere at 900 to 1,000°C for 20 to 60 minutes. Then, as shown in Figure 4E, the Si crystal grains of the polycrystalline Si layers 18 and 19, which had sizes of 2 to 5 nm, grow into Si crystal grains 22 having sizes of about 20 nm. The $SiO_2$ layer 20, which was sandwiched between the polycrystalline Si layers 18 and 19, is formed into $SiO_2$ masses 23 that are dispersed between the Si crystal grains 22.

As a result, as shown in Figure 4E, the $SiO_2$ layer 20 disappears. The polycrystalline Si layers 18 and 19 are ohmically connected and thus the polycrystalline Si layer 19 and the diffusion region 17 are also ohmically connected.

When the SRAM 11 is manufactured by this method, a resistor 13 having a resistance several times to several hundred times that of the example of Figure 1, using only the polycrystalline Si layer 18, can be formed. The stand-by current can be reduced to from 1/n to 1/100n (where n is a positive integer smaller than 10).

Furthermore, the $SiO_2$ layer does not remain as in the case of the example of Figure 2. Therefore, the resistor 13 and the drain of the FET 12 can be ohmically connected.

Growth of crystal grains as described above is also described in M. Hamasaki et al, "Crystal graphic study of Semi-insulating polycrystallize silicon (SIPOS) doped with oxygen atoms", J.A.P. 49-(7), July 1978, pp 3987 to 3992, and T. Adachi et al, "AES and PES studies of Semi-insulating polycrystallize silicon (SIPOS) films", J.E. CS Vol. 127, No. 7, July 1980, pp 1617 to 1621.

Figure 5 shows the second method embodying the invention and corresponds to Figure 4E of the first method. The second method has substantially the same steps as those of the first method except that the polycrystalline Si layer 18 is formed not on the entire surfaces of the diffusion region 17 and the $SiO_2$ layer 15, but only on the diffusion region 17 and the portion of the $SiO_2$ layer 15 near the diffusion region 17.

In the SRAM 11, the polycrystalline Si layer 19 is used as a resistor in a direction along the surface of the Si substrate 14. However, when the polycrystalline Si layer 18 is formed on the entire surface of the Si substrate 14 as shown in Figure 4E, a current also flows in the polycrystalline Si layer 18.

Since the polycrystalline Si layer 18 has a lower resistivity than that of the polycrystalline Si layer 19, the polycrystalline Si layer 18 must be made extremely thin as compared with the polycrystalline Si layer 19 in order to obtain a high overall resistance. However, it is not easy to form a very thin polycrystalline Si layer 18, and product reliability also suffers when such a thin layer is used.

As in this method, however, if the polycrystalline Si layer 18 is formed only near the diffusion region 17 to be in ohmic contact with the polycrystalline Si layer 19, a resistor portion 24 in the polycrystalline Si layer 19 serving as a resistor 13 of the SRAM 11 has a high resistance. Therefore, since the polycrystalline Si layer 18 can be formed to have a thickness of 100 to 200 nm larger than in the first method, the polycrystalline Si layer 18 can be formed easily and product reliability is improved.

In the first and second methods, the present invention is applied to the manufacture of SRAMs. However, the invention can also be applied to the manufacture of devices other than SRAMs.

**Claims**

1. A method of manufacturing a semiconductor device (11), comprising the steps of:
   forming a first polycrystalline silicon layer (18) over at least an impurity diffusion region (17) formed in a semiconductor substrate (14); and forming a second polycrystalline silicon layer (19), containing oxygen, on said first polycrystalline silicon layer (18);
characterised in that:
said second polycrystalline silicon layer (19) contains 2 to 10 atomic % of oxygen; and said semiconductor substrate (14) on which said first and second polycrystalline silicon layers (18,19) are formed is annealed in a nitrogen atmosphere at 900 to 1000˚C for 20 to 60 minutes.

2. A method according to claim 1 wherein said first and second polycrystalline silicon layers (18,19) are formed overlying the same region of said semiconductor substrate (14).

3. A method according to claim 1 wherein said first polycrystalline silicon layer (18) is formed only near said impurity diffusion region (17).

4. A method according to claim 1, claim 2 or claim 3 wherein said first polycrystalline silicon layer (18) has a thickness of 100 to 200 nm.

5. A method according to claim 1, claim 2 or claim 3 wherein said first polycrystalline silicon layer (18) has a thickness of 5 to 20 nm, and said second polycrystalline silicon layer (19) has a thickness of 150 to 400 nm.

6. A method according to any one of the preceding claims wherein P or As ions are implanted to reduce the resistance between said first polycrystalline silicon layer (18) and said impurity diffusion region (17).

7. A method according to any one of the preceding claims wherein said first and second polycrystalline silicon layers (18,19) serve as a resistor (13) of a SRAM (11).

8. A method according to claim 6 wherein said impurity diffusion region (17) is a drain region of an FET (12) of said SRAM (11).

**Revendications**

1. Procédé de fabrication d'un dispositif à semi-conducteur (11), comprenant les étapes suivantes :
la formation d'une première couche (18) de silicium polycristallin sur au moins une région diffusée (17) contenant une impureté et formée dans un substrat semi-conducteur (14), et

la formation d'une seconde couche de silicium polycristallin (19) contenant de l'oxygène, sur la première couche de silicium polycristallin (18),
caractérisé en ce que :
la seconde couche de silicium polycristallin (19) contient deux à dix atomes pour cent d'oxygène, et
le substrat semi-conducteur (14) sur lequel sont formées la première et la seconde couche de silicium polycristallin (18, 19) est recuite en atmosphère d'azote à une température comprise entre 900 et 1 000 ˚C pendant 20 à 60 min.

2. Procédé selon la revendication 1, dans lequel la première et la seconde couche de silicium polycristallin (18, 19) sont formées au-dessus de la même région du substrat semi-conducteur (14).

3. Procédé selon la revendication 1, dans lequel la première couche de silicium polycristallin (18) n'est formée qu'à proximité de la région diffusée (17) contenant l'impureté.

4. Procédé selon la revendication 1, 2 ou 3, dans lequel la première couche de silicium polycristallin (18) a une épaisseur de 100 à 200 nm.

5. Procédé selon la revendication 1, 2 ou 3, dans lequel la première couche de silicium polycristallin (18) a une épaisseur de 5 à 20 nm, et la seconde couche de silicium polycristallin (19) a une épaisseur de 150 à 400 nm.

6. Procédé selon l'une quelconque des revendications précédentes, dans lequel des ions P ou As sont implantés afin qu'ils réduisent la résistance existant entre la première couche de silicium polycristallin (18) et la région diffusée d'impureté (17).

7. Procédé selon l'une quelconque des revendications précédentes, dans lequel la première et la seconde couche de silicium polycristallin (18, 19) jouent le rôle d'une résistance (13) d'une mémoire SRAM (11).

8. Procédé selon la revendication 6, dans lequel la région diffusée (17) contenant une impureté est une région de drain d'un transistor à effet de champ (12) de la mémoire SRAM (11).

**Ansprüche**

1. Verfahren zur Herstellung eines Halbleiter-Bauelementes (11) mit folgenden Schritten:
Bildung einer ersten polykristallinen Siliciumschicht (18) über wenigstens einen Verunreinigungsdiffusionsbereich (17), der in einem Halbleitersubstrat (14) gebildet ist, und Bildung einer sauerstoffenthaltenden zweiten polykristallinen Siliciumschicht (19) auf der ersten polykristallinen Siliciumschichicht (18),
dadurch gekennzeichnet,
daß die zweite polykristalline Siliciumschicht (19) 2 bis 10 Atom-% Sauerstoff enthält und daß das Halbleitersubstrat (14), auf dem die erste und zweite polykristallinen Siliciumschicht (18) und (19) gebildet sind, in einer Stickstoff-Atmosphäre bei 900 bis 1000 °C für 20 bis 60 Minuten geglüht wird.

2. Verfahren nach Anspruch 1, bei dem die erste und zweite polykristalline Siliciumschicht (18, 19) so gebildet werden, daß sie dieselbe Fläche des Halbleiterssubstrats (14) überlagern.

3. Verfahren nach Anspruch 1, bei dem die erste polykristalline Siliciumschicht (18) nur in der Nähe des Verunreinigungsdiffusionsbereichs (17) gebildet wird.

4. Verfahren nach Anspruch 1,2 oder 3, bei dem die erste polykristalline Siliciumschicht (18) eine Dicke von 100 bis 200 nm besitzt.

5. Verfahren nach Anspruch 1, 2 oder 3, bei dem die erste polykristalline Siliciumschicht (18) eine Dicke von 5 bis 20 nm und die zweite polykristalline Siliciumschicht (19) eine Dicke von 150 bis 400 nm besitzen.

6. Verfahren nach einem der vorhergehenden Ansprüche, bei dem Phosphor- oder Arsen-Ionen eingebaut werden, um den Widerstand zwischen der ersten polykristallinen Siliciumschicht (18) und dem Verunreinigungsdiffusionsbereich (17) zu verringern.

7. Verfahren nach einem der vorhergehenden Ansprüche, bei dem erste und zweite polykristalline Siliciumschicht (18, 19) als ein Widerstand eines SRAM (11) dienen.

8. Verfahren nach Anspruch 6, bei dem der Verunreinigungsdiffusionsbereich (17) ein Drainbereich eines FET (12) des SRAM (11) ist.

*FIG.1*

*FIG.2*

*FIG.3*

## FIG.4A

## FIG.4B

## FIG.4C

*FIG.4D*

*FIG.4E*

*FIG.5*